# EUROPEAN PATENT SPECIFICATION

(11) **EP 4 646 787 B1**
(45) Date of publication and mention of the grant of the patent: **08.07.2026**
(21) Application number: 24705260.8
(22) Date of filing: 02.01.2024
(51) Int. Cl.: H03K 17/00, G01R 27/02, G01R 27/14, G01R 27/26, G06F 1/22, H03K 19/173

(54) **DETERMINATION OF VALUES INDICATIVE OF MULTIPLE PASSIVE COMPONENTS CONNECTED TO A DEVICE PIN**
BESTIMMUNG VON WERTEN, DIE MEHRERE PASSIVE, MIT EINEM GERÄTESTIFT VERBUNDENE KOMPONENTEN ANZEIGEN
DÉTERMINATION DE VALEURS INDICATIVES DE MULTIPLES COMPOSANTS PASSIFS CONNECTÉS À UNE BROCHE DE DISPOSITIF

(30) Priority: 04.01.2023 US 202318150149
(43) Date of publication of application: 12.11.2025
(73) Proprietor: Texas Instruments Incorporated, Dallas, TX 75265-5474 (US)
(72) Inventor: JING, Weibing, Beijing 100086 (CN); CHEN, Lei, Shanghai 201203 (CN); LIU, Bing, Shanghai 201203 (CN)
(74) Representative: Zeller, Andreas
(86) International application number: PCT/US2024/010011
(87) International publication number: WO 2024/147989

(56) References cited:
- CN-A- 108 718 196

## Description

### BACKGROUND

Some integrated circuits (ICs) include a pin to which an external passive component (e.g., a resistor, a capacitor, etc.) is connected. The IC can be configured for a particular setting based on a parameter associated with the passive component. For example, the resistance of a resistor may map to a desired configuration setting for the IC. In one example, the configuration setting may be for an output current limit for the IC, the switching frequency of the IC, etc.

An example can be seen in CN 108 718 196 A.

### SUMMARY

In one example, an integrated circuit (IC) includes a pin, a first passive component determination circuit, and a first switch having a first switch control input. The first switch is coupled between the first passive component determination circuit and the pin. The IC further includes a second passive component determination circuit and a second switch having a second switch control input. The second switch is coupled between the second passive component determination circuit and the pin. A logic circuit is coupled to first switch control input and to the second switch control input. The logic circuit is configured to close the first switch and open the second switch and then open the first switch and close the second switch.

### BRIEF DESCRIPTION OF THE DRAWINGS

FIG. 1 is a schematic of an example switching voltage regulator including an integrated circuit (IC) having a mode pin to which multiple passive components can be connected, in an example.
FIG. 2 is a flow chart depicting a method for sequentially determining values of the multiple passive components, in an example.
FIG. 3 is a schematic of a circuit within the IC for sequentially determining values of the multiple passive components connected to the IC's mode pin, in an example.
FIG. 4 is a timing diagram illustrating the behavior of the IC's circuit that determines the values of the multiple passive components connected to mode pin.

### DETAILED DESCRIPTION OF EXAMPLE EMBODIMENTS

The same reference numbers or other reference designators are used in the drawings to designate the same or similar (either by function and/or structure) features.

For an IC having a pin to which a single passive component is connected for configuration purposes, the number of different configuration settings depends, to a certain extent, on the resolution of the IC's circuitry to determine the passive component's parameter (e.g., resistance in the case of a resistor or capacitance in the case of a capacitor). Such passive component measurement circuitry may include an analog-to-digital converter (ADC) to convert an analog signal generated using the passive component to a digital code. The digital code is indicative of the passive component's parameter. A digital code includes one or more bits. A two-bit ADC, for example, can resolve four different levels of the passive component's parameter. In this example (a two-bit ADC), the passive component measurement circuitry permits four different values (or ranges of values) of the passive component to be connected to the IC's pin to thereby specify four different configuration settings for the IC. If it is desired to configure the IC with more than four different settings, a higher resolution ADC could be implemented but higher resolution ADCs are more complex, occupy more space on the IC, and consume more power.

The examples described herein are directed to an IC that has a configuration pin to which multiple passive components can be connected, instead of just one passive component. The IC includes circuitry that sequentially determines a value indicative of the parameter of each of the multiple passive components. For example, in the example described herein, the passive components include a resistor coupled in parallel to a capacitor between the IC's configuration pin and ground. The circuitry first determines a value indicative of the resistance of the resistor, and then determines a value indicative of the capacitance of the capacitor. By permitting two passive components, each with its permitted multiple levels of parameters or ranges of parameters, a larger number of configuration settings can be implemented by the IC than would have otherwise have been the case for a pin measurement circuit that has a low-resolution ADC.

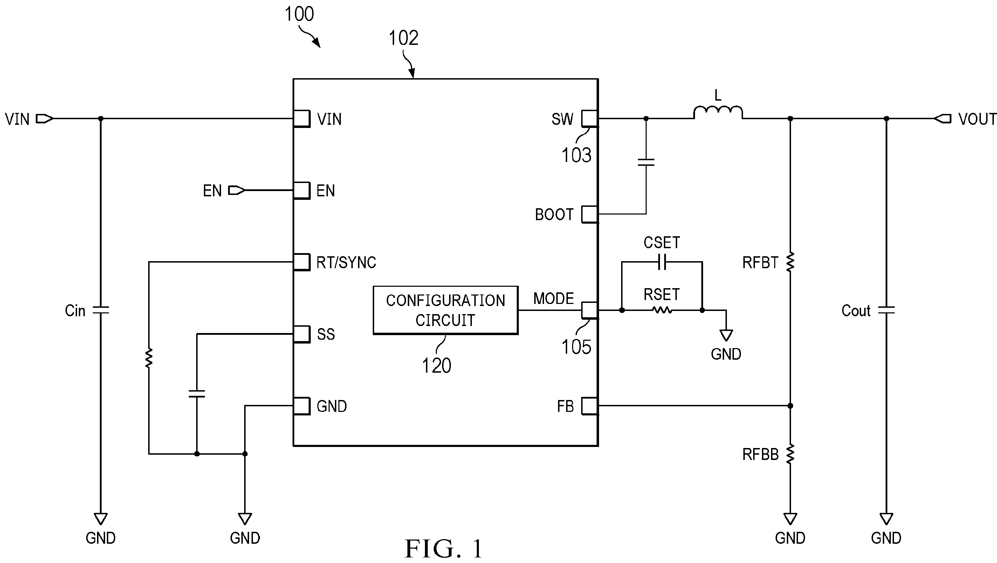

FIG. 1 is a schematic illustrating an example of an IC 102 usable as part of a switching voltage regulator 100. The switching voltage regulator 100 converts an input direct current (DC) voltage, VIN, to a regulated output voltage, VOUT. In this example, the IC 102 includes internal power transistors (not shown) connected in series between VIN and ground (GND). A controller (not shown) internal to the IC 102 such as a pulse width modulator (PWM) controls the ON and OFF states of the power transistors. The switch node (SW) between the power transistors is exposed as a pin 103 of the IC. A number of external passive components are connected to various pins of the IC 102. In one example, the IC 102 and the passive components are mounted on the same circuit board. The passive components may be connected to the IC via conductive traces on the circuit board. In the example, of FIG. 1 one terminal of an inductor L is coupled to the SW node pin 103, and the other terminal of the inductor provides VOUT. Resistors R_{FBT} and R_{FBB} are connected in series between VOUT and ground to implement a voltage divider to provide a scaled-down output voltage to a feedback (FB) pin of the IC 102. The IC 102 may be used in a variety of voltage converter applications. In one example, the IC 102 may be a controller for buck converter. In another example, the IC 102 (or other types of such ICs) may be a controller for a boost converter. In another example, the IC 102 may be used for a buck-boost converter.

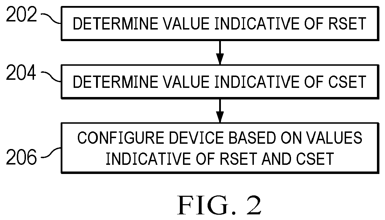

The configuration pin described above is shown in the example of FIG. 1 as the mode pin (MODE) 105. Two passive components are shown coupled between the MODE pin 105 and ground-resistor R_{SET} is coupled in parallel with capacitor C_{SET}. Referring to FIG. 1 and FIG. 2 (FIG. 2 is a flow chart), a configuration circuit 120 internal to the IC 102 and described below sequentially determines (step 202) a value indicative of the resistance of resistor R_{SET}, and then determines (step 204) a value indicative of the capacitance of capacitor C_{SET}. At step 206, the values indicative of the passive components R_{SET} and C_{SET} are then used by the configuration circuit 120 to configure at least one parameter associated with the IC 102 (e.g., output current limit, switching frequency, etc.).

The example IC 102 in FIG. 1 is a controller for a voltage regulator. The techniques and circuity described herein, however, are applicable to any IC in which it is desirable to specify at least one configuration setting from multiple configuration settings by way of external passive components connected to a single pin.

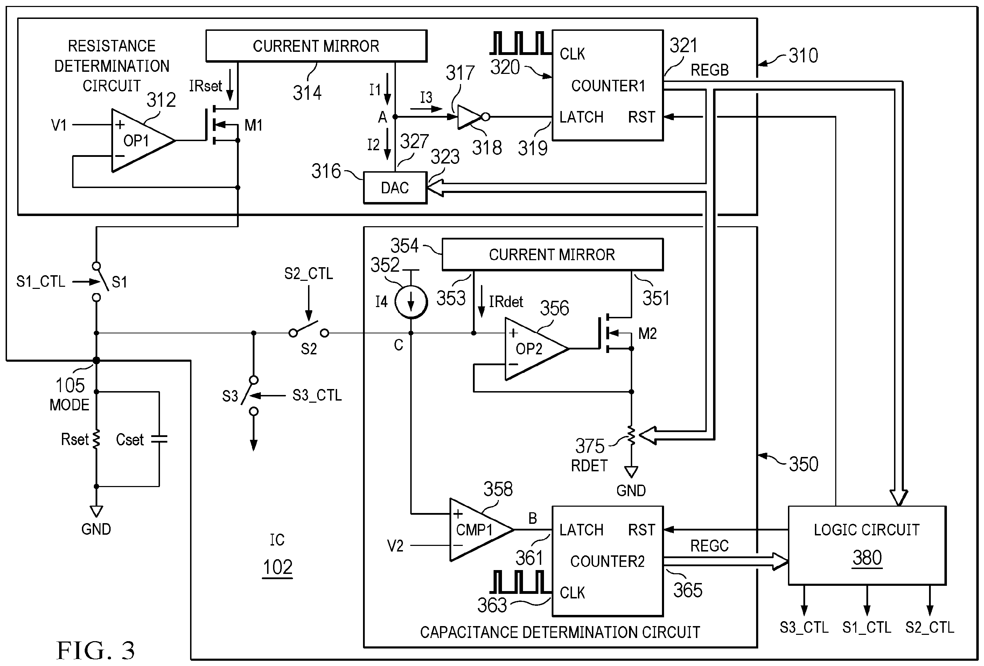

FIG. 3 is a schematic of an example of the configuration circuit 120. Other than the resistor R_{SET} and the capacitor C_{SET}, the components shown in the example of FIG. 3 are part of the configuration circuit 120 implemented on the IC having a mode pin 105 to which resistor R_{SET} and the capacitor C_{SET} are connected.

The configuration circuit 120 in the example of FIG 3 includes a resistance determination circuit 310, a capacitance determination circuit 350, switches S1, S2, and S3, and a logic circuit 380. Switch S1 is coupled between the resistance determination circuit 310 and pin 105. Switch S2 is coupled between the capacitance determination circuit 350 and pin 105. The resistance determination circuit 310 determines a value indicative of the resistance of resistor R_{SET} when switch S1 is closed and switch S2 is open. The capacitance determination circuit 350 determines a value indicative of the capacitance of capacitor C_{SET} when switch S2 is closed and switch S1 is open. The logic circuit 380 provides switch control signals S1_CTL and S2_CTL to control the open and closed (OFF and ON) status of switches S1 and S2, respectively. In one example, to determine the values indicative of the resistance and capacitance of resistor R_{SET} and capacitor C_{SET}, respectively, the logic circuit 380 first causes switch S1 to be closed and switch S2 to be opened to thereby cause the resistance determination circuit 310 to produce a digital output value, REGR, indicative of the resistance of resistor R_{SET}. Then, circuit 380 causes switch S1 to be open and switch S2 to be closed to thereby cause the capacitance determination circuit 350 to produce a digital value indicative of the capacitance of capacitor C_{SET}. Upon determining the value indicative of the resistance of resistor R_{SET}, a charge will be present across capacitor C_{SET}. After determining the resistance of resistor R_{SET} and before determining the capacitance of capacitor C_{SET}, the logic circuit 380 asserts a switch control signal S3_CTL to cause switch S3 to close and capacitor CSET to discharge through switch S3 to ground.

The resistance determination circuit 310 includes an operational amplifier (OP AMP) 312, a current mirror 314, a digital-to-analog converter (DAC) 316, a logic gate 318, a counter 320, and a transistor M1. In this example, transistor M1 is an n-channel field effect transistor (NFET). In other examples, transistor M1 can be implemented as a different type of transistor. The logic gate 318 is an inverter in this example.

The OP AMP 312 includes a non-inverting (positive, +) input, an inverting (negative, -) input, and an output. A direct current (DC) voltage V1 is provided to the non-inverting input. The source of transistor M1 is coupled to the negative input of OP AMP 312. The output of OP AMP 312 is coupled to the gate of transistor M1. OP AMP 312 and transistor M1 function as a voltage-to-current converter converting voltage V1 to a current IRset. The voltage on the non-inverting input of OP AMP 312 is also provided on the inverting input and thus on the source of transistor M1. Because the source of transistor M1 is coupled to resistor R_{SET}, the voltage across resistor RESET is V1. The current through resistor RESET is IRset. A larger magnitude of voltage V1 results in a larger magnitude for current IRset, and vice versa. The magnitude of voltage V1 can be any voltage in a fairly wide range.

The current mirror 314 mirrors current IRset as current 11. The current mirror ratio implemented by current mirror 314 may be 1:1 or another suitable ratio. The current mirror 314 couples to DAC 316 and to the input 317 of logic gate 318 (e.g., inverter) at node A. The current into the DAC 316 is current I2. The current in to, or out of, the logic gate 318 is current I3. The sum of currents I2 and I3 equals current I1 from the current mirror 316. The output of logic gate 318 is coupled to a latch input 319 of counter 320. Responsive to the latch input being at one logic state (e.g., logic "1"), the counter 320 counts pulses of a clock signal provided on its clock input 311 and produces successively increasing digital codes (RegR) on its output 321 and holds its output code RegR at the value present when the latch input transitioned to logic 1. Responsive to the latch being at another logic state (e.g., logic "0"), the counter 320 ceases incrementing its output digital code. The counter can be reset by a signal provided on its reset (RST) input. For example, a logic "1" on its reset input causes the counter to set its output digital count back to 0.

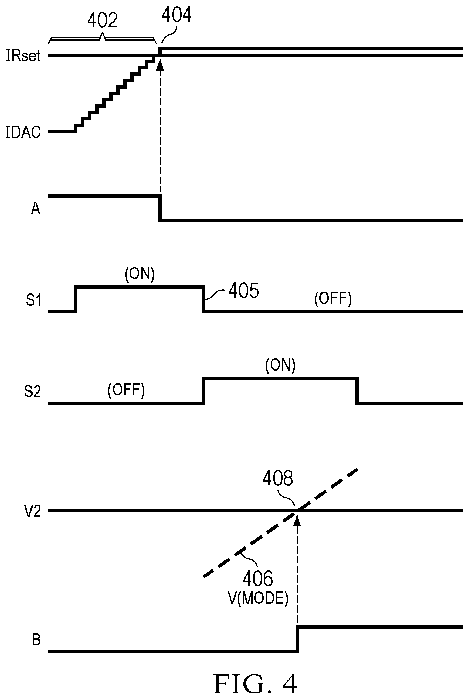

The output 321 of counter 320 is coupled to the digital input 323 of DAC 316. The DAC 316 responds to each successively increasing digital code RegR by increasing the magnitude of current I2 at analog output 327. When the magnitude of current I1 is larger than the magnitude of current I2, current I3 flows into the logic gate 318, and the voltage on node A is logic high. FIG. 4 is a timing diagram that illustrates the voltage on node A is logic high (402) as the DAC's output current increases but is still smaller than current I1 (and current I1 is a function of, for example equal to, current IRset).

Responsive to the digital code RegR being large enough for DAC 316 to force current I2 to equal and exceed current I1, current I3 becomes negative (discharges the input 317 of logic gate 318) and the node A voltage becomes logic low. This transition is shown at 404 in FIG. 4. Responsive to the node A voltage becoming logic low, the latch input 319 of counter 320 becomes logic high, and the counter freezes its output digital code RegR. When the counter 320 ceases counting (responsive to the DAC's output current I2 reaching current 11), the value of RegR at that point is indicative of the resistance of resistor R_{SET}. A larger resistance of resistor R_{SET} causes current IRset to be larger. A larger value of current IRset causes current mirror 314 to produce a larger current I1. The counter 320 will take more time to count from a digital output code of 0 to a value at which current I2 equals current I1, and thus the RegR digital code will be larger. Similarly, a smaller resistance of resistor RSET causes current IRset to be smaller. A smaller value of current IRset causes current mirror 314 to produce a smaller current I1. The counter 320 will take less time to count from a digital output code of 0 to a value at which current I2 equals current I1, and thus the RegR digital code will be smaller.

During the time that switch S1 is closed (ON), switches S2 and S3 are open (OFF), voltage V1 is also forced across capacitor C_{SET}. With a DC voltage across the plates of capacitor C_{SET}, little or no current flows into capacitor C_{SET}. Thus, the digital code RegR represents the resistance value of resistor R_{SET}. Before determining a value indicative of the capacitance of capacitor C_{SET}, the logic 380 asserts switch control signal S3_CTL to close switch S3 to close long enough to discharge capacitor C_{SET}.

During the next phase of operation in which the capacitance determination circuit 350 determines a value of indicative of the capacitance of capacitor C_{SET}, the logic circuit 380 asserts control signals S1_CTL, S2_CTL, and S3_CTL to cause switches S1 and S3 to be open (OFF) and switch S2 to be closed (ON). The timing diagram of FIG. 4 shows switch S1 turned OFF and switch S2 turned ON at 405.

The capacitance determination circuit 350 includes a current source circuit 352, a current mirror 354, an OP AMP 356, a comparator 358, a counter 360, transistor M2, and a resistor R_{DET}. Switch S2 is coupled between the current source circuit 350 (at node C) and the parallel combination of resistor R_{SET} and capacitor C_{SET}. The current source circuit 350 produces a current 14. Switch S2 is also coupled to the non-inverting input of OP AMP 356. The inverting input of OP AMP 356 is coupled to the source of transistor M2 and to resistor R_{DET}. Resistor R_{DET} is coupled between the source of transistor M2 and ground. In this example, transistor M2 is an NFET. The drain of transistor M2 is coupled to one terminal 351 of current mirror 354, and the other terminal 353 of current mirror 354 is coupled through switch S2 to the capacitor C_{SET}/resistor R_{SET} parallel combination.

The non-inverting input of comparator 358 is coupled to switch S2, current source circuit 352, current mirror 354, and the non-inverting input of OP AMP 356 at node C. A DC threshold voltage V2 is provided to the inverting input of comparator 358. The output of comparator 358 is coupled to the latch input 361 of counter 360. The node coupling the output of the comparator and the latch input of the counter is labeled node B. The counter 360 counts pulses of a clock signal on its clock input 363 responsive to the voltage on the latch input 361 being at one logic state (e.g., logic 0). In this example, the counter 360 is an up-counter and thus increments its digital output code REGC on its output 365 with each successive pulse of the clock input signal. Responsive to the logic level on the logic input 361 being at a different logic state (e.g., logic), the counter 360 ceases counting and freezes its output digital code REGC.

Current source circuit 352 forces a constant level current I4 into the parallel combination of capacitor C_{SET} and resistor R_{SET}. The voltage across the capacitor C_{SET} is the voltage on the mode pin 105 and is referred to as Vmode. Responsive to capacitor C_{SET} being charged by a fixed current I4, the voltage across capacitor C_{SET} (Vmode) increases approximately linearly as shown at 406 in Fig. 4. The slope of Vmode is inversely related to the capacitance of capacitor C_{SET}-a larger value of the capacitance of capacitor C_{SET} causes the slope of Vmode to be smaller, and a smaller value of the capacitance of capacitor C_{SET} causes the slope of Vmode to be larger.

Comparator 358 compares voltage Vmode to V2 and produces an output signal indicative of whether Vmode is larger or smaller than V2. The output of comparator 358 is coupled to the latch 361 of counter 360. The counter 360 increments its digital code REGC starting, for example, from 0 when its reset (RST) input is forced high by logic 380 until Vmode equals V2. When Vmode reaches V2 (point 408 in FIG. 4), the logic level of the latch input 361 of comparator 358 changes state and counter 360 ceases incrementing REGC. The value of REGC at that point is a function of the capacitance of capacitor C_{SET}.

The function performed by the combination of OP AMP 356, transistor M2, resistor R_{DET}, and current mirror 354 is create a current to approximately equal the current that flows through resistor R_{SET}. As a result, the current IRdet from current mirror 354 offsets the current through resistor R_{SET}, so that the counter 360 produces a digital code REGC that more accurately indicates the capacitance of capacitor C_{SET}.

In this example, the resistor R_{DET} is a configurable resistor. The configurable resistor R_{DET} has a resistor control input 375, which is coupled to the counter output 321. The digital code REGR, which is indicative of resistor R_{SET}, is provided to the resistor control input 375. The resistance of resistor R_{DET} is configured based on the digital code REGR. In one example, the configurable resistor R_{DET} includes multiple resistors, each coupled to a switch (e.g., in series with the switch or in parallel with the switch), and the digital code REGR controls the ON and OFF state of the switches to select just those resistors to be electrically coupled between the source of transistor M2 and ground to thereby approximate the resistance of resistor R_{SET}.

The voltage Vmode is applied to across resistor R_{SET}. The same voltage Vmode also is coupled to the non-inverting input of OP AMP 356. Through the OP AMP 356, the same voltage Vmode also is applied across resistor R_{DET}. Thus, both resistors R_{SET} and configurable resistor R_{DET} have the same voltage. With configurable resistor R_{DET} set for a resistance approximately equal to the resistance of resistor R_{SET}, both resistors have approximately the same current. The current mirror 354 mirrors the current through transistor M2 and resistor R_{DET} as current IRdet, which flows through resistor R_{SET} while switch S2 is closed.

Logic 380 receives digital codes REGR and REGC. Digital code REGR is indicative of the resistance of resistor R_{SET}. Digital code REGC is indicative of the capacitance of capacitor C_{SET}. Logic 380, or other logic circuitry within IC 102 may configure one or more parameters about the operation of the IC based on both the REGB and REGC digital codes. Non-limiting examples of such configuration parameters are provided above. A technical benefit of the resistance determination circuit 310, capacitance determination circuit 350, switches S1 and S2, and logic 380 is that only a single a pin 105 need be available on the IC to which multiple passive components can be connected. Multiple pins (each pin for a separate passive component) are not needed. In some examples, however, multiple pins such as pin 105 may be included so that three, four or more passive components can be coupled to the IC for configuration parameter purposes.

In this description, the term "couple" may cover connections, communications, or signal paths that enable a functional relationship consistent with this description. For example, if device A generates a signal to control device B to perform an action: (a) in a first example, device A is coupled to device B by direct connection; or (b) in a second example, device A is coupled to device B through intervening component C if intervening component C does not alter the functional relationship between device A and device B, such that device B is controlled by device A via the control signal generated by device A.

Also, in this description, the recitation "based on" means "based at least in part on." Therefore, if X is based on Y, then X may be a function of Y and any number of other factors.

A device that is "configured to" perform a task or function may be configured (e.g., programmed and/or hardwired) at a time of manufacturing by a manufacturer to perform the function and/or may be configurable (or reconfigurable) by a user after manufacturing to perform the function and/or other additional or alternative functions. The configuring may be through firmware and/or software programming of the device, through a construction and/or layout of hardware components and interconnections of the device, or a combination thereof.

As used herein, the term "pin" refers to any suitable type of electrical contact to one or more components fabricated on an IC. Different types of packages are available for ICs such as a flat package, a pin grid array, a surface mount package, a chip carrier, a small outline package, etc. Examples of a flat package include a quad-flat no-lead (QFN) package and a dual-flat no-lead (DFN) package. Some packages may have leads, while other packages may not have leads. Regardless of the package type the "pin" described herein is the electrical contact to the circuitry fabricated on the die.

A circuit or device that is described herein as including certain components may instead be adapted to be coupled to those components to form the described circuitry or device. For example, a structure described as including one or more semiconductor elements (such as transistors), one or more passive elements (such as resistors, capacitors, and/or inductors), and/or one or more sources (such as voltage and/or current sources) may instead include only the semiconductor elements within a single physical device (e.g., a semiconductor die and/or integrated circuit (IC) package) and may be adapted to be coupled to at least some of the passive elements and/or the sources to form the described structure either at a time of manufacture or after a time of manufacture, for example, by an end-user and/or a third-party.

While the use of particular transistors is described herein, other transistors (or equivalent devices) may be used instead with little or no change to the remaining circuitry. For example, a field effect transistor ("FET") (such as an n-channel FET (NFET) or a p-channel FET (PFET)), a bipolar junction transistor (BJT - e.g., NPN transistor or PNP transistor), an insulated gate bipolar transistor (IGBT), and/or a junction field effect transistor (JFET) may be used in place of or in conjunction with the devices described herein. The transistors may be depletion mode devices, drain-extended devices, enhancement mode devices, natural transistors or other types of device structure transistors. Furthermore, the devices may be implemented in/over a silicon substrate (Si), a silicon carbide substrate (SiC), a gallium nitride substrate (GaN) or a gallium arsenide substrate (GaAs).

References may be made in the claims to a transistor's control input and its current terminals. In the context of a FET, the control input is the gate, and the current terminals are the drain and source. In the context of a BJT, the control input is the base, and the current terminals are the collector and emitter.

References herein to a FET being "ON" means that the conduction channel of the FET is present and drain current may flow through the FET. References herein to a FET being "OFF" means that the conduction channel is not present so drain current does not flow through the FET. An "OFF" FET, however, may have current flowing through the transistor's body-diode.

Circuits described herein are reconfigurable to include additional or different components to provide functionality at least partially similar to functionality available prior to the component replacement. Components shown as resistors, unless otherwise stated, are generally representative of any one or more elements coupled in series and/or parallel to provide an amount of impedance represented by the resistor shown. For example, a resistor or capacitor shown and described herein as a single component may instead be multiple resistors or capacitors, respectively, coupled in parallel between the same nodes. For example, a resistor or capacitor shown and described herein as a single component may instead be multiple resistors or capacitors, respectively, coupled in series between the same two nodes as the single resistor or capacitor.

While certain elements of the described examples are included in an integrated circuit and other elements are external to the integrated circuit, in other examples, additional or fewer features may be incorporated into the integrated circuit. In addition, some or all of the features illustrated as being external to the integrated circuit may be included in the integrated circuit and/or some features illustrated as being internal to the integrated circuit may be incorporated outside of the integrated. As used herein, the term "integrated circuit" means one or more circuits that are: (i) incorporated in/over a semiconductor substrate; (ii) incorporated in a single semiconductor package; (iii) incorporated into the same module; and/or (iv) incorporated in/on the same printed circuit board.

Uses of the phrase "ground" in the foregoing description include a chassis ground, an Earth ground, a floating ground, a virtual ground, a digital ground, a common ground, and/or any other form of ground connection applicable to, or suitable for, the teachings of this description. In this description, unless otherwise stated, "about," "approximately" or "substantially" preceding a parameter means being within +/- 10 percent of that parameter or, if the parameter is zero, a reasonable range of values around zero.

Modifications are possible in the described examples, and other examples are possible, within the scope of the claims.

## Claims

1. An integrated circuit, IC, (102) comprising:
a pin (105);
a current mirror (314);
a first switch (S1) coupled between the current mirror (314) and the pin (105);
a counter (320) having a counter control input and a counter output, wherein the counter (320) is configured to increment a digital value at its counter output until a signal at the counter control input changes logic state;
a digital-to-analog converter, DAC, (316) having a digital input and an analog output, the analog output coupled to the current mirror (314) and to the counter control input, and the digital input coupled to the counter output;
a current source circuit (352); and
a second switch (S2) coupled between the current source circuit (352) and the pin (105).

2. The IC of claim 1, further comprising a logic circuit (380) coupled to the first switch (S1) and to the second switch (S2), the logic circuit (380) configured to close the first switch (S1) and open the second switch (S2) and then to open the first switch (S1) and close the second switch (S2).

3. The IC of claim 1, further comprising:
a transistor having a transistor control input, a first current terminal, and a second current terminal, the first current terminal coupled to the current mirror, and the second current terminal coupled to the first switch; and
an operational amplifier (OP AMP) having a first OP AMP input and an OP AMP output, the first OP AMP input coupled to second current terminal, and the OP AMP output coupled to the transistor control input.

4. The IC of claim 1, wherein the current mirror is a first current mirror, and the IC further comprises:
a second current mirror coupled to the current source circuit and to the second switch; and
a configurable resistor having a resistor control input, the counter output coupled to the resistor control input.

5. The IC of claim 4, wherein the counter is a first counter, the resistor control input is a first counter control input, and the IC further comprises:
a second counter having a second counter control input; and
a comparator having a first comparator input, a second comparator input, and a comparator output, the current source circuit and the second current mirror coupled to the first comparator input, and the comparator output coupled to the second counter control input.

6. The IC of claim 5, wherein the configurable resistor is coupled between the second current mirror and a ground terminal.

7. The IC of claim 4, wherein the second current mirror has a first current mirror terminal and a second current mirror terminal, the first current mirror terminal coupled to the current source circuit and to the second switch, and the IC further comprises:
a transistor having a first current terminal and a second current terminal, the first current terminal coupled to the second current mirror terminal, and the second current terminal coupled to the configurable resistor.

8. The IC of claim 7, wherein the transistor has a transistor control input, and the IC further comprises an operational amplifier (OP AMP) having a first OP AMP input, a second OP AMP input, and an OP AMP output, the first OP AMP input coupled to the first current mirror terminal and to the current source circuit, the second OP AMP input coupled to the second current terminal, and the OP AMP output coupled to the transistor control input.

9. The IC of claim 1, further comprising:
the pin;
the current source circuit;
the second switch coupled between the current source circuit and the pin;
a first current mirror having a current mirror terminal, the second switch coupled between the current mirror terminal and the pin;
the counter having a control input;
a comparator having a first comparator input, a second comparator input, and a comparator output, the first comparator input coupled to the current source circuit and to the current mirror terminal, and the comparator output coupled to the control input;
a second current mirror; and
the first switch coupled between the second current mirror and the pin.

10. The IC of claim 9, wherein the current mirror terminal is a first current mirror terminal, the first current mirror has a second current mirror terminal, and the IC further comprises a resistor coupled between the second current mirror terminal and a ground terminal.

11. The IC of claim 10, wherein the resistor is a configurable resistor.

12. The IC of claim 10, wherein the second current mirror has a third current mirror terminal and a fourth current mirror terminal, the first switch coupled between the third current mirror terminal and the pin, and the IC further comprises:
a digital-to-analog converter, DAC, having a digital input and an analog output, the analog output coupled to the fourth current mirror terminal.

13. The IC of claim 12, wherein the counter is a first counter, and the control input is a first counter control input, and the IC further comprises:
a second counter having a second counter control input and a counter output, the counter output coupled to the digital input.

14. The IC of claim 9, wherein the current mirror terminal is a first current mirror terminal, the first current mirror has a second current mirror terminal, and the IC further comprises:
a resistor;
a transistor having a transistor control input, a first current terminal, and a second current terminal, the first current terminal coupled to the second current mirror terminal, and the second current terminal coupled to the resistor; and
an operational amplifier (OP AMP) having a first OP AMP input, a second OP AMP input, and an OP AMP output, the first OP AMP input coupled to the current source circuit, the second OP AMP input coupled to the second current terminal, the OP AMP output coupled to the transistor control input.

## Patentansprüche

1. Integrierte Schaltung, IC, (102), umfassend:
einen Stift (105);
einen Stromspiegel (314);
einen ersten Schalter (S1), der zwischen dem Stromspiegel (314) und dem Stift (105) gekoppelt ist;
einen Zähler (320) mit einem Zählersteuereingang und einem Zählerausgang, wobei der Zähler (320) dazu ausgelegt ist, einen digitalen Wert an seinem Zählerausgang zu inkrementieren, bis ein Signal am Zählersteuereingang den logischen Zustand ändert;
einen Digital-Analog-Wandler, DAC, (316) mit einem digitalen Eingang und einem analogen Ausgang, wobei der analoge Ausgang mit dem Stromspiegel (314) und mit dem Zählersteuereingang gekoppelt ist und der digitale Eingang mit dem Zählerausgang gekoppelt ist;
eine Stromquellenschaltung (352); und
einen zweiten Schalter (S2), der zwischen der Stromquellenschaltung (352) und dem Stift (105) gekoppelt ist.

2. IC nach Anspruch 1, ferner umfassend eine Logikschaltung (380), die mit dem ersten Schalter (S1) und mit dem zweiten Schalter (S2) gekoppelt ist, wobei die Logikschaltung (380) dazu ausgelegt ist, den ersten Schalter (S1) zu schließen und den zweiten Schalter (S2) zu öffnen und dann den ersten Schalter (S1) zu öffnen und den zweiten Schalter (S2) zu schließen.

3. IC nach Anspruch 1, ferner umfassend:
einen Transistor mit einem Transistorsteuereingang, einem ersten Stromanschluss und einem zweiten Stromanschluss, wobei der erste Stromanschluss mit dem Stromspiegel gekoppelt ist und der zweite Stromanschluss mit dem ersten Schalter gekoppelt ist; und
einen Operationsverstärker (OP AMP) mit einem ersten OP-AMP-Eingang und einem OP-AMP-Ausgang, wobei der erste OP-AMP-Eingang mit dem zweiten Stromanschluss gekoppelt ist und der OP-AMP-Ausgang mit dem Transistorsteuereingang gekoppelt ist.

4. IC nach Anspruch 1, wobei der Stromspiegel ein erster Stromspiegel ist und die IC ferner Folgendes umfasst:
einen zweiten Stromspiegel, der mit der Stromquellenschaltung und mit dem zweiten Schalter gekoppelt ist; und
einen konfigurierbaren Widerstand mit einem Widerstandssteuereingang, wobei der Zählerausgang mit dem Widerstandssteuereingang gekoppelt ist.

5. IC nach Anspruch 4, wobei der Zähler ein erster Zähler ist, der Widerstandssteuereingang ein erster Zählersteuereingang ist und die IC ferner Folgendes umfasst:
einen zweiten Zähler mit einem zweiten Zählersteuereingang; und
einen Komparator mit einem ersten Komparatoreingang, einem zweiten Komparatoreingang und einem Komparatorausgang, wobei die Stromquellenschaltung und der zweite Stromspiegel mit dem ersten Komparatoreingang gekoppelt sind und der Komparatorausgang mit dem zweiten Zählersteuereingang gekoppelt ist.

6. IC nach Anspruch 5, wobei der konfigurierbare Widerstand zwischen dem zweiten Stromspiegel und einem Masseanschluss gekoppelt ist.

7. IC nach Anspruch 4, wobei der zweite Stromspiegel einen ersten Stromspiegelanschluss und einen zweiten Stromspiegelanschluss aufweist, wobei der erste Stromspiegelanschluss mit der Stromquellenschaltung und mit dem zweiten Schalter gekoppelt ist und die IC ferner Folgendes umfasst:
einen Transistor mit einem ersten Stromanschluss und einem zweiten Stromanschluss, wobei der erste Stromanschluss mit dem zweiten Stromspiegelanschluss gekoppelt ist und der zweite Stromanschluss mit dem konfigurierbaren Widerstand gekoppelt ist.

8. IC nach Anspruch 7, wobei der Transistor einen Transistorsteuereingang aufweist und die IC ferner einen Operationsverstärker (OP AMP) mit einem ersten OP-AMP-Eingang, einem zweiten OP-AMP-Eingang und einem OP-AMP-Ausgang umfasst, wobei der erste OP-AMP-Eingang mit dem ersten Stromspiegelanschluss und mit der Stromquellenschaltung gekoppelt ist, der zweite OP-AMP-Eingang mit dem zweiten Stromanschluss gekoppelt ist und der OP-AMP-Ausgang mit dem Transistorsteuereingang gekoppelt ist.

9. IC nach Anspruch 1, ferner umfassend:
den Stift;
die Stromquellenschaltung;
wobei der zweite Schalter zwischen der Stromquellenschaltung und dem Pin gekoppelt ist;
einen ersten Stromspiegel mit einem Stromspiegelanschluss, wobei der zweite Schalter zwischen dem Stromspiegelanschluss und dem Stift gekoppelt ist;
wobei der Zähler einen Steuereingang aufweist;
einen Komparator mit einem ersten Komparatoreingang, einem zweiten Komparatoreingang und einem Komparatorausgang, wobei der erste Komparatoreingang mit der Stromquellenschaltung und mit dem Stromspiegelanschluss gekoppelt ist und der Komparatorausgang mit dem Steuereingang gekoppelt ist;
einen zweiten Stromspiegel; und
wobei der erste Schalter zwischen dem zweiten Stromspiegel und dem Stift gekoppelt ist.

10. IC nach Anspruch 9, wobei der Stromspiegelanschluss ein erster Stromspiegelanschluss ist, der erste Stromspiegel einen zweiten Stromspiegelanschluss aufweist und die IC ferner einen Widerstand umfasst, der zwischen dem zweiten Stromspiegelanschluss und einem Masseanschluss gekoppelt ist.

11. IC nach Anspruch 10, wobei der Widerstand ein konfigurierbarer Widerstand ist.

12. IC nach Anspruch 10, wobei der zweite Stromspiegel einen dritten Stromspiegelanschluss und einen vierten Stromspiegelanschluss aufweist, wobei der erste Schalter zwischen dem dritten Stromspiegelanschluss und dem Stift gekoppelt ist und die IC ferner Folgendes umfasst:
einen Digital-Analog-Wandler, DAC, mit einem digitalen Eingang und einem analogen Ausgang, wobei der analoge Ausgang mit dem vierten Stromspiegelanschluss gekoppelt ist.

13. IC nach Anspruch 12, wobei der Zähler ein erster Zähler ist und der Steuereingang ein erster Zählersteuereingang ist und die IC ferner Folgendes umfasst:
einen zweiten Zähler mit einem zweiten Zählersteuereingang und
einem Zählerausgang, wobei der Zählerausgang mit dem digitalen Eingang gekoppelt ist.

14. IC nach Anspruch 9, wobei der Stromspiegelanschluss ein erster Stromspiegelanschluss ist, der erste Stromspiegel einen zweiten Stromspiegelanschluss aufweist und die IC ferner Folgendes umfasst:
einen Widerstand;
einen Transistor mit einem Transistorsteuereingang, einem ersten Stromanschluss und einem zweiten Stromanschluss, wobei der erste Stromanschluss mit dem zweiten Stromspiegelanschluss gekoppelt ist und der zweite Stromanschluss mit dem Widerstand gekoppelt ist; und
einen Operationsverstärker (OP AMP) mit einem ersten OP- AMP-Eingang, einem zweiten OP-AMP-Eingang und einem OP-AMP-Ausgang, wobei der erste OP-AMP-Eingang mit der Stromquellenschaltung gekoppelt ist, der zweite OP-AMP-Eingang mit dem zweiten Stromanschluss gekoppelt ist, der OP-AMP-Ausgang mit dem Transistorsteuereingang gekoppelt ist.

## Revendications

1. Circuit intégré, CI, (102), comprenant :
une broche (105) ;
un miroir de courant (314) ;
un premier commutateur (S1) couplé entre le miroir de courant (314) et la broche (105) ;
un compteur (320) ayant une entrée de commande de compteur et une sortie de compteur, le compteur (320) étant configuré pour incrémenter une valeur numérique à sa sortie de compteur jusqu'à ce qu'un signal au niveau de l'entrée de commande de compteur change d'état logique ;
un convertisseur numérique-analogique, CNA, (316) ayant une entrée numérique et une sortie analogique, la sortie analogique étant couplée au miroir de courant (314) et à l'entrée de commande de compteur, et l'entrée numérique étant couplée à la sortie de compteur ;
un circuit de source de courant (352) ; et
un deuxième commutateur (S2) couplé entre le circuit de source de courant (352) et la broche (105).

2. CI selon la revendication 1, comprenant en outre un circuit logique (380) couplé au premier commutateur (S1) et au deuxième commutateur (S2), le circuit logique (380) étant configuré pour fermer le premier commutateur (S1) et ouvrir le deuxième commutateur (S2) puis pour ouvrir le premier commutateur (S1) et fermer le deuxième commutateur (S2).

3. CI selon la revendication 1, comprenant en outre :
un transistor ayant une entrée de commande de transistor, une première borne de courant et une deuxième borne de courant, la première borne de courant étant couplée au miroir de courant, et la deuxième borne de courant étant couplée au premier commutateur ; et
un amplificateur opérationnel (AMP OP) ayant une première entrée d'AMP OP et une sortie d'AMP OP, la première entrée d'AMP OP étant couplée à une deuxième borne de courant, et la sortie d'AMP OP étant couplée à l'entrée de commande de transistor.

4. CI selon la revendication 1, le miroir de courant étant un premier miroir de courant, et le CI comprenant en outre :
un deuxième miroir de courant couplé au circuit de source de courant et au deuxième commutateur ; et
une résistance configurable ayant une entrée de commande de résistance, la sortie de compteur étant couplée à l'entrée de commande de résistance.

5. CI selon la revendication 4, le compteur étant un premier compteur, l'entrée de commande de résistance étant une première entrée de commande de compteur, et le CI comprenant en outre :
un deuxième compteur ayant une deuxième entrée de commande de compteur ; et
un comparateur ayant une première entrée de comparateur, une deuxième entrée de comparateur et une sortie de comparateur, le circuit de source de courant et le deuxième miroir de courant étant couplés à la première entrée de comparateur, et la sortie de comparateur étant couplée à la deuxième entrée de commande de compteur.

6. CI selon la revendication 5, la résistance configurable étant couplée entre le deuxième miroir de courant et une borne de terre.

7. CI selon la revendication 4, le deuxième miroir de courant ayant une première borne de miroir de courant et une deuxième borne de miroir de courant, la première borne de miroir de courant étant couplée au circuit de source de courant et au deuxième commutateur, et le CI comprenant en outre :
un transistor ayant une première borne de courant et une deuxième borne de courant, la première borne de courant étant couplée à la deuxième borne de miroir de courant, et la deuxième borne de courant étant couplée à la résistance configurable.

8. CI selon la revendication 7, le transistor ayant une entrée de commande de transistor, et le CI comprenant en outre un amplificateur opérationnel (AMP OP) ayant une première entrée d'AMP OP, une deuxième entrée d'AMP OP, et une sortie d'AMP OP, la première entrée d'AMP OP étant couplée à la première borne miroir de courant et au circuit de source de courant, la deuxième entrée d'AMP OP étant couplée à la deuxième borne de courant, et la sortie d'AMP OP étant couplée à l'entrée de commande de transistor.

9. CI selon la revendication 1, comprenant en outre :
la broche ;
le circuit de source de courant ;
le deuxième commutateur couplé entre le circuit de source de courant et la broche ;
un premier miroir de courant ayant une borne de miroir de courant, le deuxième commutateur étant couplé entre la borne de miroir de courant et la broche :
le compteur ayant une entrée de commande ;
un comparateur ayant une première entrée de comparateur, une deuxième entrée de comparateur, et une sortie de comparateur, la première entrée de comparateur étant couplée au circuit de source de courant et à la borne de miroir de courant, et la sortie de comparateur étant couplée à l'entrée de commande ;
un deuxième miroir de courant ; et
le premier commutateur couplé entre le deuxième miroir de courant et la broche.

10. CI selon la revendication 9, la borne de miroir de courant étant une première borne de miroir de courant, le premier miroir de courant ayant une deuxième borne de miroir de courant, et le CI comprenant en outre une résistance couplée entre la deuxième borne de miroir de courant et une borne de terre.

11. CI selon la revendication 10, la résistance étant une résistance configurable.

12. CI selon la revendication 10, le deuxième miroir de courant ayant une troisième borne de miroir de courant et une quatrième borne de miroir de courant, le premier commutateur étant couplé entre la troisième borne de miroir de courant et la broche, et le CI comprenant en outre :
un convertisseur numérique-analogique, CNA, ayant une entrée numérique et une sortie analogique, la sortie analogique étant couplée à la quatrième borne miroir de courant.

13. CI selon la revendication 12, le compteur étant un premier compteur, et l'entrée de commande étant une première entrée de commande de compteur, et le CI comprenant en outre :
un deuxième compteur ayant une deuxième entrée de commande de compteur et une sortie de compteur, la sortie de compteur étant couplée à l'entrée numérique.

14. CI selon la revendication 9, la borne de miroir de courant étant une première borne de miroir de courant, le premier miroir de courant ayant une deuxième borne de miroir de courant, et le CI comprenant en outre :
une résistance ;
un transistor ayant une entrée de commande de transistor, une première borne de courant et une deuxième borne de courant, la première borne de courant étant couplée à la deuxième borne de miroir de courant, et la deuxième borne de courant étant couplée à la résistance ; et
un amplificateur opérationnel (AMP OP) ayant une première entrée d'AMP OP, une deuxième entrée d'AMP OP et une sortie d'AMP OP, la première entrée d'AMP OP étant couplée au circuit de source de courant, la deuxième entrée d'AMP OP étant couplée à la deuxième borne de courant, la sortie d'AMP OP étant couplée à l'entrée de commande de transistor.
